# EUROPEAN PATENT SPECIFICATION

(11) **EP 2 720 361 B1**
(45) Date of publication and mention of the grant of the patent: **07.12.2016**
(21) Application number: 12797021.8
(22) Date of filing: 01.03.2012
(51) Int. Cl.: H02M 3/155, H01L 23/538, H02M 1/00, H02M 7/00, H02M 1/44, H02M 3/158

(54) **MULTI-CHANNEL TYPE DC/DC CONVERTER**
MEHRKANAL-GLEICHSTROMWANDLER
CONVERTISSEUR CC/CC DE TYPE MULTICANAUX

(30) Priority: 10.06.2011 JP 2011130260
(43) Date of publication of application: 16.04.2014
(73) Proprietor: Murata Manufacturing Co., Ltd., Nagaokakyo-shi, Kyoto 617-8555 (JP)
(72) Inventor: HIEI Tomoyoshi, Nagaokakyo-shi Kyoto 617-8555 (JP)
(74) Representative: Herrmann, Uwe
(86) International application number: PCT/JP2012/055183
(87) International publication number: WO 2012/169242

(56) References cited:
- EP-A1- 2 106 014
- EP-A2- 0 844 625
- WO-A1-2008/087781
- WO-A1-2010/103910
- JP-A- 2005 141 719
- JP-A- 2005 158 767
- JP-A- 2006 340 535
- JP-A- 2011 097 755
- US-A1- 2006 113 664

## Description

### Technical Field

The present invention relates to DC-DC converters in which switching elements are mounted and particularly relates to multichannel DC-DC converters.

### Background Art

In the related art, DC-DC converters realized by forming a coil pattern inside a magnetic substrate and mounting a switching IC on an upper portion of the magnetic substrate are known (for example, refer to Patent Document 1).

In addition, multichannel DC-DC converters constructed by forming a plurality of coils inside a single magnetic substrate are also known (for example, refer to Patent Document 2).

### Citation List

### Patent Documents

Patent Document 1: International Publication No. 2008/087781
Patent Document 2: Japanese Unexamined Patent Application Publication No. 2004-343976

### Summary of Invention

### Technical Problem

In the case of the above-described DC-DC converters, since the wiring lines between Vout terminals of a switching IC and coils are most liable to be affected by noise, it is preferable that the wiring lines between the Vout terminals and the coils be as short as.possible.

However, in general, the Vout terminals of a switching IC are concentrated in one place. In such a case, channels for which relatively long wiring lines are necessary, among wiring lines connected from Vout terminals of the switching IC to each of the coils, are inevitably created on the upper surface of the magnetic substrate.

Consequently, it is an object of the present invention to provide a multichannel DC-DC converter in which the effect of noise is suppressed to a minimum.

### Solution to Problem

A multichannel DC-DC converter of the present invention includes a multilayer body inside of which a plurality of coil conductors are formed, a plurality of land electrodes that are provided on a main surface of the multilayer body and that are electrically connected to the plurality of coil conductors via connection wiring lines, and a control IC that is connected to the plurality of land electrodes and that has a plurality of input terminals or output terminals. The multichannel DC-DC converter is characterized by the connection wiring line that is connected to the coil conductor having the smallest current among the plurality of coil conductors being the longest connection wiring line.

Thus, the wiring line between the coil conductor of a channel having the smallest.load current and the switching IC, among the coil conductors forming a plurality of channels, is made to be the longest wiring line, whereby a channel having the smallest noise is used with a wiring line which is most liable to be affected by noise and the effect of noise can be suppressed to a minimum.

In addition, it is preferable that the connection wiring line connected to a coil conductor having the largest current among the plurality of coil conductors be the shortest connection wiring line. In this case, a channel having the largest noise is used with a wiring line that is least liable to be affected by noise, whereby the effect of noise can be further suppressed.

### Advantageous Effects of Invention

According to the present invention, even in the case where a switching IC is employed in which terminals are concentrated in one place, the effect of noise can be suppressed to a minimum.

### Brief Description of Drawings

[Fig. 1] Fig. 1 illustrates a top view and a cross-sectional view of a multichannel DC-DC converter.
[Fig. 2] Fig. 2 is a circuit diagram for a case in which the multichannel DC-DC converter is a step-down DC-DC converter.
[Fig. 3] Fig. 3 is a circuit diagram for a case in which the multichannel DC-DC converter is a step-up DC-DC converter.

### Description of Embodiments

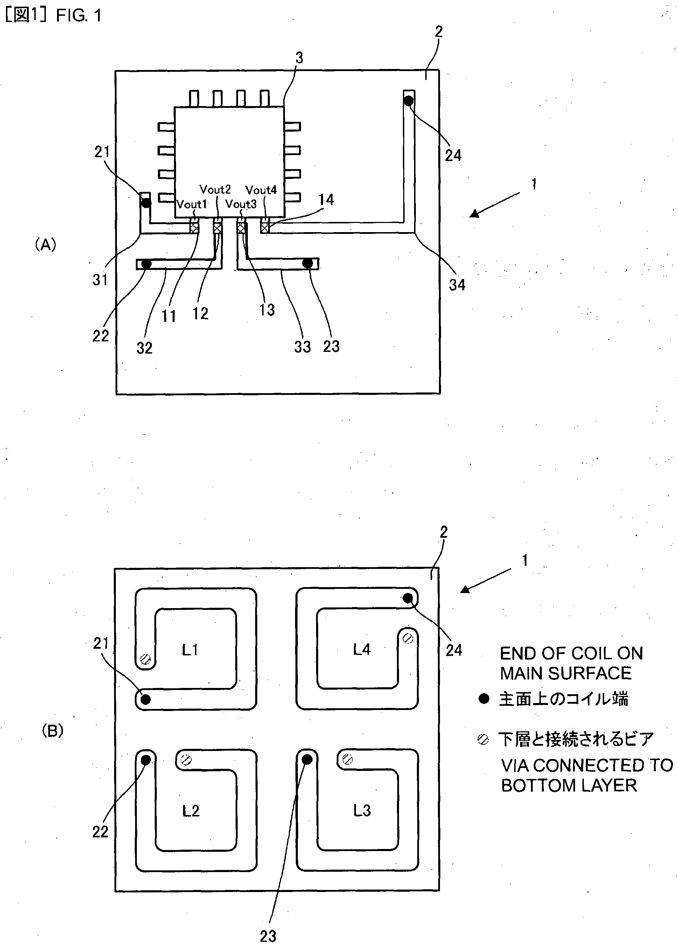

Fig. 1(A) is a top view of a multichannel DC-DC converter according to an embodiment of the present invention (diagram illustrating main surface of multilayer body) and Fig. 1(B) is a cross-sectional view of a part of the multilayer body in which coil conductors are formed.

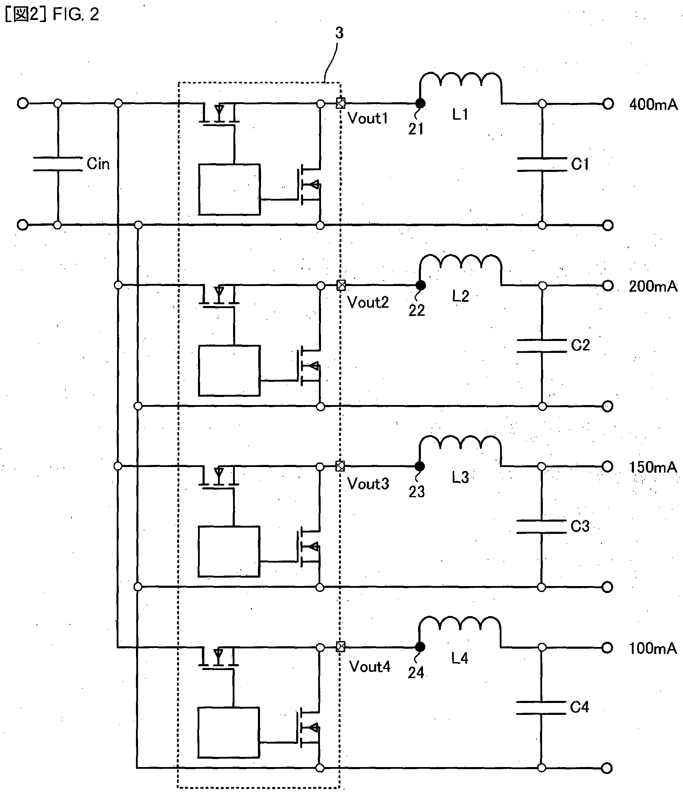

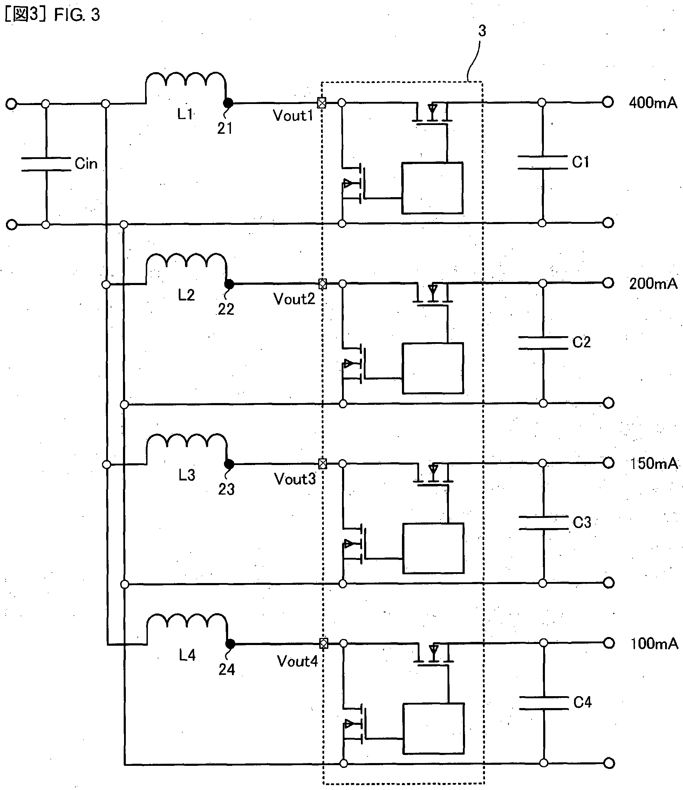

Fig. 2. is a circuit diagram for the case where the multichannel DC-DC converter of this embodiment is a step-down DC-DC converter, and Fig. 3 is a circuit diagram for the case where the multichannel DC-DC converter of this embodiment is a step-up DC-DC converter.

As illustrated in Fig. 1(A) and Fig. 1(B), in a multichannel DC-DC converter 1 of this embodiment, electronic components, such as a switching IC 3 and capacitors (not illustrated in Fig. 1) are mounted on the uppermost surface of a multilayer body 2, which is formed by stacking a plurality of ceramic green sheets on top of one another. The multilayer body 2 includes magnetic (ferrite) layers and for example is provided with coil conductors between stacked sheets, the coil conductors being connected to one another in the stacking direction to form inductors. In this way, a DC-DC converter can be realized that utilizes the inductors as choke coils.

As illustrated in Fig. 1(B), a plurality of coil conductors are provided in the multilayer body 2 of the present embodiment. By connecting switching elements driven at different duties to the plurality of coil conductors, different output voltages can be obtained. The multichannel DC-DC converter 1 of this embodiment is a four-channel DC-DC converter provided with a coil conductor L1, a coil conductor L2, a coil conductor L3, and a coil conductor L4.

On the uppermost surface of the multilayer body 2, a land electrode 11, a land electrode 12, a land electrode 13 and a land electrode 14, to which the switching IC 3 is connected, are formed. In addition, a connection wiring line 31, a connection wiring line 32, a connection wiring line 33 and a connection wiring line 34, which are respectively connected to a main-surface-side end portion 21 of the coil conductor L1, a main-surface-side end portion 22 of the coil conductor L2, a main-surface-side end portion 23 of the coil conductor L3 and a main-surface-side end portion 24 of the coil conductor L4, are formed on the uppermost surface of the multilayer body 2.

The switching IC 3 has a square-shaped exterior when viewed in plan and terminals protrude from the four sides thereof. Four switching elements are integrated into the inside of the switching IC 3 and four switching node terminals (Vout terminals) protrude from one side of the switching IC 3. These four Vout terminals are respectively connected to the land electrode 11, the land electrode 12, the land electrode 13 and the land electrode 14, and are respectively connected to the coil conductor L1, the coil conductor L2, the coil conductor L3 and the coil conductor L4 via the connection wiring line 31, the connection wiring line 32, the connection wiring line 33 and the connection wiring line 34.

As illustrated in Fig. 2, in the case of a step-down DC-DC converter, the Vout terminals (Vout1, Vout2, Vout3 and Vout4) are respectively connected to input sides of the coil conductor L1, the coil conductor L2, the coil conductor L3 and the coil conductor L4. As illustrated in Fig. 3, in the case of a step-up DC-DC converter, the Vout terminals (Vout1, Vout2, Vout3 and Vout4) are respectively connected to the output sides of the coil conductor L1, the coil conductor L2, the coil conductor L3 and the coil conductor L4, and therefore the Vout terminals serve as input terminals in reality.

Since capacitors and so forth are mounted on the uppermost surface of the multilayer body 2, the switching IC 3 is mounted at a position that is shifted from the center of the uppermost surface of the multilayer body 2. In this embodiment, the switching IC 3 is mounted at a position at the top left of the figure in Fig. 1(A). With a DC-DC converter having such a switching scheme, since signals onto which switching noise has been maximally superimposed flow through the wiring lines between the Vout terminals of the switching IC 3 and the coil conductors, radiation noise is liable to become large. Consequently, it is preferable that the connection wiring lines be as short as possible. However, since the switching IC 3 is mounted at a position shifted from the center of the main surface and the Vout terminals are concentrated on a single side of the switching IC 3, the distances between the Vout terminals (Vout1, Vout2, Vout3 and Vout4) and the main-surface-side end portions of the coil conductors are different from one another and the lengths of the connection wiring line 31, the connection wiring line 32, the connection wiring line 33 and the connection wiring line 34 are different from one another.

Consequently, the multichannel DC-DC converter 1 of this embodiment is structured so as to suppress radiation of noise to a minimum by making the connection wiring line of a channel having the smallest load current be the longest connection wiring line.

The positional relationship between the constituent elements will be described with reference to Fig. 1(A) and Fig. 1(B). The switching IC 3 is mounted at a position in the top left of the figure and the Vout terminals are arranged on a center side of the multilayer body 2. The Vout terminals are arranged in the order of Vout1, Vout2, Vout3 and Vout4 from the left side of the figure. The coil conductor L1 is arranged at the top left in the figure, and the main-surface-side end portion 21 is arranged at the bottom left of the coil conductor L1 in the figure. The coil conductor L2 is arranged at the bottom left in the figure, and the main-surface-side end portion 22 is arranged at the top left of the coil conductor L2 in the figure. The coil conductor L3 is arranged at the bottom right in the figure, and the main-surface-side end portion 23 is arranged at the top left of the coil conductor L3 in the figure. The coil conductor L4 is arranged at the top right in the figure, and the main-surface-side end portion 24 is arranged at the top right of the coil conductor L4 in the figure.

Therefore, on the uppermost surface of the multilayer body 2, the main-surface-side end portion 21 of the coil conductor L1 is arranged slightly above the center and on the left side in the figure, the main-surface-side end portion 22 of the coil conductor L2 is arranged slightly below the center and on left side in the figure, the main-surface-side end portion 23 of the coil conductor L3 is arranged slightly below and to the right of the center and the main-surface-side end portion 24 of the coil conductor L4 is arranged at the top right in the figure.

Consequently, the main-surface-side end portion 21 is closest to the corresponding Vout terminal and the main-surface-side end portion 24 is farthest away from the corresponding Vout terminal. Therefore, among the Vout terminals, the connection wiring line 31, which connects Vout1 arranged on the leftmost side and the main-surface-side end portion 21, is the shortest connection wiring line and the connection wiring line 34, which connects Vout4 and the main-surface-side end portion 24, is the longest connection wiring line.

Consequently, the coil conductor L1, which has the largest load current, is connected to the Vout1 channel and the coil conductor L4, which has the smallest load current, is connected to the Vout4 channel. In this embodiment, the load current of the coil conductor L1 is 400 mA, the load current of the coil conductor L2 is 200 mA, the load current of the coil conductor L3 is 150 mA and the load current of the coil conductor L4 is 100 mA.

Thus, by making the connection wiring line 34 between the coil conductor L4 of the channel having the smallest load current, among the coil conductors forming a plurality of channels, and the Vout terminal (Vout4) of the switching IC 3 be the longest connection wiring line, the channel having the smallest load current is used with the wiring line which is most liable to radiate noise, whereby radiation noise can be suppressed to a minimum.

In addition, the connection wiring line 31 between the coil conductor L1, which has the largest load current among, the coil conductors forming the plurality of channels, and the Vout terminal (Vout1) of the switching IC 3 is made to be the shortest connection wiring line, whereby the channel having the largest load current is used with the wiring line that is not liable to radiate noise, whereby radiation noise can be further suppressed.

The multichannel DC-DC converter of this embodiment has four channels and therefore includes the coil conductor L2 having a load current of 200 mA and the coil conductor L3 having a load current of 150 mA. In this embodiment, the length of the connection wiring line 32 between the coil conductor L2 and the Vout terminal (Vout2) of the switching IC 3 and the length of the connection wiring line 33 between the coil conductor L3 and the Vout terminal (Vout3) of the switching IC 3 are substantially the same, but it is preferable that the length of the connection wiring line 32 of the coil conductor L2 for which the load current is larger be made shorter than the length of the connection wiring line 33. However, in the present invention, it is important to use the channel having the smallest load current with the connection wiring line 34 which is most liable to radiate noise, but, for the other channels, it is not essential to use wiring lines whose lengths increase in order of the smallness of the load currents of the channels with which they are used.

In the case where a DC-DC converter has even more channels, radiation noise can be suppressed to a minimum by making the connection wiring line between the coil conductor of a channel having the smallest load current and the Vout terminal of the switching IC be the longest connection wiring line, as in the wiring line connection relationship described in this embodiment. In addition, radiation noise can be further suppressed by making the connection wiring line between the coil conductor having the largest load current and the Vout terminal of the switching IC be the shortest connection wiring line.

In addition, in the multichannel DC-DC converter of this embodiment, the main-surface-side end portion 21 is closest to the corresponding Vout terminal and the main-surface-side end portion 24 is furthest away from the corresponding Vout terminal, but for example in a case where the main-surface-side end portion 24 is arranged close to the center of the multilayer body 2, the main-surface-side end portion 24 is closest to the corresponding Vout terminal. In this case, the channel having the largest load current may be connected to the longest connection wiring line (for example, the connection wiring line 33). In addition, in this case, the connection wiring line 34 is the shortest connection wiring line and therefore the channel having the largest load current may be connected to the connection wiring line 34.

### Reference Signs List

- 1: DC-DC converter
- 2: multilayer body
- 3: switching IC
- 11, 12, 13, 14: land electrode
- 21, 22, 23, 24: main-surface-side end portion
- 31, 32, 33, 34: connection wiring line

## Claims

1. A multichannel DC-DC converter comprising
a multilayer body inside of which a plurality of coil conductors are formed,
a plurality of land electrodes that are provided on a main surface of the multilayer body and that are electrically connected to the plurality of coil conductors via connection wiring lines, and
a control IC that is connected to the plurality of land electrodes and that has a plurality of input terminals or output terminals,
wherein the connection wiring line that is connected to the coil conductor having the smallest load current among the plurality of coil conductors is the longest connection wiring line.

2. The multichannel DC-DC converter'according to Claim 1, wherein the connection wiring line connected to the coil conductor having the largest load current among the plurality of coil conductors is the shortest connection wiring line.

## Patentansprüche

1. Mehrkanal-Gleichstromwandler, umfassend
einen mehrlagigen Körper, in dessen Inneren eine Vielzahl von Spulenleitern ausgebildet ist,
eine Vielzahl von Bodenelektroden, die auf einer Hauptfläche des mehrlagigen Körpers vorgesehen sind und die mit der Vielzahl von Spulenleitern über Verbindungsdrahtleitungen elektrisch verbunden sind, und
eine integrierte Steuerschaltung, die mit der Vielzahl von Bodenelektroden verbunden ist und die eine Vielzahl von Eingangsanschlüssen oder Ausgangsanschlüssen besitzt,
wobei die Verbindungsdrahtleitung, die mit dem Spulenleiter mit dem kleinsten Laststrom unter der Vielzahl von Spulenleitern verbunden ist, die längste Verbindungsdrahtleitung ist.

2. Mehrkanal-Gleichstromwandler nach Anspruch 1, wobei die Verbindungsdrahtleitung, die mit dem Spulenleiter mit dem größten Laststrom unter der Vielzahl von Spulenleitern verbunden ist, die kürzeste Verbindungsdrahtleitung ist.

## Revendications

1. Convertisseur continu-continu à canaux multiples, comportant
un corps multicouche dans lequel une pluralité de conducteurs de bobine sont formés,
une pluralité d'électrodes de terre qui sont prévues sur une surface principale du corps multicouche et qui sont connectées électriquement à la pluralité de conducteurs de bobine par l'intermédiaire de lignes de connexion câblées, et
un circuit intégré de commande qui est connecté à la pluralité d'électrodes de terre et qui possède une pluralité de bornes d'entrée ou de bornes de sortie,
dans lequel la ligne de connexion câblée qui est connectée au conducteur de bobine ayant le courant de charge le plus petit entre la pluralité de conducteurs de bobine est la ligne de connexion câblée la plus longue.

2. Convertisseur continu-continu à canaux multiples selon la revendication 1, dans lequel la ligne de connexion câblée qui est connectée au conducteur de bobine ayant le courant de charge le plus grand entre la pluralité de conducteurs de bobine est la ligne de connexion câblée la plus courte.
